# EUROPEAN PATENT APPLICATION

(11) **EP 4 815 683 A1**
(43) Date of publication of application: **30.09.2026**
(21) Application number: 25217276.2
(22) Date of filing: 20.11.2025
(51) Int. Cl.: H10F 77/70

(54) **SOLAR CELL AND MANUFACTURING METHOD THEREFOR, AND PHOTOVOLTAIC MODULE**

(30) Priority: 27.03.2025 CN 202510376656
(71) Applicant: Jinko Solar (Haining) Co., Ltd., Haining City, Zhejiang (CN)
(72) Inventor: GUO, Jiadong, Haining City, Zhejiang Province (CN); CHEN, Qin, Haining City, Zhejiang Province (CN); CHEN, Jinjin, Haining City, Zhejiang Province (CN); WANG, Zhao, Haining City, Zhejiang Province (CN); ZHENG, Peiting, Haining City, Zhejiang Province (CN); YANG, Jie, Haining City, Zhejiang Province (CN); ZHANG, Xinyu, Haining City, Zhejiang Province (CN)
(74) Representative: Balder IP Law, S.L.

(57) **Abstract**

Provided are a solar cell and a photovoltaic module. The solar cell includes a substrate having a first surface and an opposing second surface. The first surface includes a first region and a second region alternately formed along a first direction, and the first region has a first textured surface that includes a plurality of first pyramids. A respective first pyramid of at least some of the plurality of first pyramids includes a main body portion and enclosing portions formed on a lateral surface and connected along a direction perpendicular to the lateral surface. The main body portion is a pyramid-like structure having a plurality of lateral edges connected with adjacent lateral edges, and a respective enclosing portion of the enclosing portions extends toward the bottom surface along a second direction. A protruding block protruding relative to the bottom surface is formed at an end of the respective enclosing portion.

## Description

### TECHNICAL FIELD

The various embodiments described in this document relate in general to the photovoltaic field, and more specifically to a solar cell and a manufacturing method therefor, and a photovoltaic module.

### BACKGROUND

With the gradual depletion of fossil energy resources, solar cells have become increasingly popular as a new alternative energy source. A solar cell is a device that converts solar energy into electrical energy. The solar cell generates charge carriers using the photovoltaic effect and then uses grid lines to extract the charge carriers, thereby enabling the effective utilization of the generated electrical energy.

The surface texturing technology of solar cells is an important operation in the modem solar cell manufacturing process. By forming a pyramid-shaped textured surface structure on a surface of the solar cell through chemical etching, a surface reflectivity of the solar cell can be reduced, thereby increasing a density of photogenerated charge carriers and improving the photovoltaic conversion efficiency.

However, various texturing techniques are available, and many factors can affect the texturing treatment. The reflectivity of the resulting textured surface structure still needs to be further reduced.

### SUMMARY

The present disclosure provides a solar cell and a manufacturing method therefor, and a photovoltaic module, which are at least conducive to reducing the reflectivity of a first region to light, thereby improving the photoelectric conversion efficiency of the solar cell.

In one aspect, the present disclosure provides a solar cell, including: a substrate including a first surface and an opposing second surface, where the first surface has a first region and a second region alternately formed along a first direction, and the first region has a first textured surface including a plurality of first pyramids. A respective first pyramid of at least some of the plurality of first pyramids includes a main body portion and enclosing portions formed on a lateral surface of the main body portion and stacked in a direction perpendicular to the lateral surface. The main body portion is a pyramid-like structure having a plurality of lateral edges, and a lateral surface is between two adjacent lateral edges. The main body portion further includes a bottom surface connecting the plurality of lateral surfaces, a respective enclosing portion of the enclosing portions extends toward the bottom surface along a second direction, and includes a respective protruding block at an end of the respective enclosing portion away from the bottom surface and protruding out of an adjacent enclosing portion on a side of the respective enclosing portion away from the main body portion.

In some embodiments, the protruding block includes an extension surface extending toward the bottom surface along the second direction that is parallel to the lateral surface, and a step surface connecting the main body portion and the extension surface, or connecting adjacent extension surfaces, and an angle between the step surface and the second direction is less than or equal to 90°.

In some embodiments, the step surface is a substantially flat surface or a curved surface.

In some embodiments, a portion of the main body portion includes a pit away from the bottom surface.

In some embodiments, a portion of the enclosing portions surrounds the plurality of lateral surfaces of the main body portion, and/or a number of enclosing portions formed on different lateral surfaces is the same or different.

In some embodiments, the respective enclosing portion of the enclosing portions has an end face at the bottom surface of the main body portion, and the bottom surface and end faces of the enclosing portions form a base of the respective first pyramid.

In some embodiments, an included angle between two opposite lateral edges of the main body portion is in a range from 40° to 50°.

In some embodiments, the solar cell further includes a first doped semiconductor layer doped with a first dopant formed on the second region, and portions of the substrate in the first region are recessed toward the second surface.

In some embodiments, the solar cell further includes a tunneling layer formed on the second surface; a second doped semiconductor layer doped with a second dopant and formed on a side of the tunneling layer away from the second surface, where the first dopant and the second dopant have different conductivity types; a first passivation layer formed on a side of the first doped semiconductor layer away from the substrate and on the first region; a second passivation layer formed on a side of the second doped semiconductor layer away from the tunneling layer; a first electrode embedded in the first passivation layer and in ohmic contact with the first doped semiconductor layer; and a second electrode embedded in the second passivation layer and in ohmic contact with the second doped semiconductor layer.

In some embodiments, the second region has a polished flat surface or a second textured surface, and the second textured surface includes a plurality of second pyramids; where an included angle between two opposite lateral edges of the main body portion is less than an included angle between two opposite lateral edges of the second pyramid; and/or in a same arrangement area, a number of second pyramids arranged is less than a number of first pyramids arranged; and/or a height of the second pyramid is greater than a height of the first pyramid.

In another aspect, the present disclosure provides a method for manufacturing a solar cell, including: providing an initial substrate, where the initial substrate includes an initial first surface and an opposing initial second surface, and the initial first surface includes an initial first region and an initial second region alternately arranged along a first direction; performing a first texturing treatment on the initial first region using a first etching solution containing a first additive to form a plurality of initial first pyramids, where the first additive is used to slow down an etching rate of the initial substrate during the first texturing treatment; and performing a second texturing treatment on the initial first region using a second etching solution containing a second additive. During the second texturing treatment, the second additive is adsorbed on at least portions of surfaces of the plurality of initial first pyramids, and the portions of surfaces of the plurality of initial first pyramids with the second additive function as a protected region, and the second additive is used to slow down an etching rate of the protected region during the second texturing treatment, to convert the initial first region into a first region having a first textured surface including a plurality of first pyramids, a remaining portion of the initial substrate serves as the substrate, and the initial second region functions as a second region of the substrate. A respective first pyramid of at least some of the plurality of first pyramids includes a main body portion and enclosing portions formed on a lateral surface of the main body portion and stacked in a direction perpendicular to the lateral surface. The main body portion is a pyramid-like structure having a plurality of lateral edges, and a lateral surface is between two adjacent lateral edges. The main body portion further includes a bottom surface connecting the plurality of lateral surfaces, a respective enclosing portion of the enclosing portions extends toward the bottom surface along a second direction, and includes a respective protruding block at an end of the respective enclosing portion away from the bottom surface and protruding out of an adjacent enclosing portion on a side of the respective enclosing portion away from the main body portion.

In some embodiments, a material of the first additive includes a cellulose active agent containing carboxyl and aldehyde groups, and a material of the second additive includes a surface ionic active agent.

In some embodiments, an included angle between two opposite lateral edges of a respective initial first pyramid of the plurality of initial first pyramids is in a range from 50° to 60°.

In some embodiments, the initial first surface has a second textured surface including a plurality of second pyramids. After providing the initial substrate and before performing the first texturing treatment, the method further includes: forming a first doped semiconductor film doped with a first dopant on the initial first surface; and performing a laser processing on a portion of the first doped semiconductor film and a portion of the initial substrate in the initial first region to remove the portion of the first doped semiconductor film in the initial first region, and to remove the second pyramids in the initial first region, such that the portion of the initial substrate in the initial first region is recessed toward the initial second surface, and a remaining portion of the first doped semiconductor film in the initial second region serves as the first doped semiconductor layer.

In some embodiments, the method further includes: forming a tunneling layer on the second surface; forming a second doped semiconductor layer doped with a second dopant, where the second doped semiconductor layer is formed on a side of the tunneling layer away from the second surface, and the first dopant and the second dopant have different conductivity types; forming a first passivation layer, where the first passivation layer is formed on a side of the first doped semiconductor layer away from the substrate and on the first region; forming a second passivation layer, where the second passivation layer is formed on a side of the second doped semiconductor layer away from the tunneling layer; forming a first electrode, where the first electrode is embedded in the first passivation layer and in ohmic contact with the first doped semiconductor layer; and forming a second electrode, where the second electrode is embedded in the second passivation layer and in ohmic contact with the second doped semiconductor layer.

In some embodiments, the first passivation layer and the second passivation layer are formed using a plasma-enhanced chemical vapor deposition (PECVD) process. A structure on the substrate where the first doped semiconductor layer, the tunneling layer, and the second doped semiconductor layer are formed is taken as a target structure, and during the PECVD process, the target structure is placed in a graphite boat, and a number of contact locking points between the graphite boat and the target structure are greater than or equal to five.

In some embodiments, the target structure has four sides, each of two opposing sides of the four sides has at least two respective contact locking points that are spaced from each other and configured to lock with the graphite boat, and one of the other two sides of the four sides has at least one contact locking point configured to lock with the graphite boat.

In yet another aspect, the present disclosure further provides a photovoltaic module, including at least one cell string, which is formed by connecting a plurality of solar cells according to any of the foregoing embodiments, or by connecting the solar cells formed using the manufacturing method according to any of the foregoing embodiments; at least one encapsulant film configured to cover a surface of the at least one cell string; and at least one cover plate configured to cover a surface of the at least one encapsulant film away from the at least one cell string.

The technical solutions provided by the present disclosure at least have the following advantages.

A surface of the first pyramid according to some embodiments of the present disclosure is designed to be rougher than that of a conventional pyramid. Specifically, the surface of the first pyramid is enclosed layer-by-layer by a plurality of enclosing portions. A respective enclosing portion of the enclosing portions includes a protruding block raised relative to a bottom surface, such that the surface of the first pyramid has a plurality of protruding blocks, a surface roughness of the first pyramid is greatly increased, thereby enhancing a light-trapping effect of the first pyramid on incident light. Consequently, a reflectivity of the first textured surface including rough-surfaced first pyramids is further reduced, allowing a second region to absorb more light and generate more charge carriers. This effectively increases the short-circuit current and improves the photovoltaic conversion efficiency of the solar cell.

### BRIEF DESCRIPTION OF THE DRAWINGS

One or more embodiments are illustrated with reference to the accompanying drawings, and such exemplary description does not constitute a limitation on the embodiments. The figures in the accompanying drawings do not constitute a scale limitation unless otherwise stated. In order to more clearly illustrate technical solutions in the embodiments of the present disclosure or in the prior art, a brief description of the accompanying drawings used in the embodiments will be provided below. Obviously, the accompanying drawings in the following description illustrate only some embodiments of the present disclosure, and those skilled in the art may derive other drawings from these drawings without inventive effort.
FIG. 1 is a first schematic diagram of a partial sectional view of a solar cell according to some embodiments of the present disclosure.
FIG. 2 is a second schematic diagram of a partial sectional view of a solar cell according to some embodiments of the present disclosure.
FIG. 3 is one enlarged schematic diagram of the dashed box I of the structure shown in FIG. 1 or 2.
FIG. 4 is a perspective view of a main body portion of the structure shown in FIG. 3.
FIG. 5 is a perspective view of a scanning electron microscope (SEM) of a first region of a solar cell according to some embodiments of the present disclosure.
FIG. 6 is a schematic diagram of a top view of a first region of a solar cell according to some embodiments of the present disclosure.
FIG. 7 is another enlarged schematic diagram of the dashed box I of the structure shown in FIG. 1 or 2.
FIG. 8 is an enlarged schematic diagram of the dashed box II of the structure shown in FIG. 6.
FIG. 9 is a third schematic diagram of a partial sectional view of a solar cell according to some embodiments of the present disclosure.
FIG. 10 is a fourth schematic diagram of a partial sectional view of a solar cell according to some embodiments of the present disclosure.
FIG. 11 is a schematic diagram of a partial sectional view of an initial substrate provided in a method for manufacturing a solar cell according to some embodiments of the present disclosure.
FIG. 12 is a schematic diagram of a partial sectional view of the structure shown in FIG. 11 after a first texturing treatment.
FIG. 13 is a schematic diagram of a partial sectional view illustrating a stage after formation of a first doped semiconductor film in a method for manufacturing a solar cell according to some embodiments of the present disclosure.
FIG. 14 is a schematic diagram of a partial sectional view of the structure shown in FIG. 13 after laser processing.
FIG. 15 is a schematic diagram of a partial sectional view of the structure shown in FIG. 14 after a first texturing treatment.
FIG. 16 is a partial perspective view of a photovoltaic module according to some embodiments of the present disclosure.
FIG. 17 is a sectional view of the photovoltaic module in FIG. 16 in a cross-sectional direction MM1.

### DETAILED DESCRIPTION OF THE EMBODIMENTS

As known from the background, the surface reflectivity of solar cells needs to be further reduced.

Analysis has revealed that there are various texturing techniques, and many factors influence the texturing treatment. For example, bubbles formed during the texturing treatment can affect the texturing efficiency, and varying concentrations of texturing solutions may also result in excessively fast or slow texturing rate, ultimately affecting the growth efficiency and size of the pyramids, thereby affecting the reflectivity of textured surface.

Some embodiments of the present disclosure provide a solar cell, a manufacturing method therefor, and a photovoltaic module. In the solar cell according to some embodiments of the present disclosure, surfaces of the first pyramids in a second region are designed to be rougher than that of a conventional pyramid. Specifically, the surfaces of the first pyramids are enclosed layer-by-layer by a plurality of enclosing portions. A respective enclosing portion of the enclosing portions includes a protruding block raised relative to a bottom surface, such that the surface of the first pyramid has a plurality of protruding blocks, a surface roughness of the first pyramid is greatly increased, thereby enhancing a light-trapping effect of the first pyramid on incident light. Consequently, a reflectivity of the first textured surface including rough-surfaced first pyramids is further reduced, allowing a second region to absorb more light and generate more charge carriers. This effectively increases the short-circuit current and improves the photovoltaic conversion efficiency of the solar cell.

In the description of the embodiments of the present disclosure, the technical terms "first," "second," and the like, are merely used to distinguish one element from another and should not be construed as indicating or implying relative importance, or implying the number, specific sequence, or priority of the technical features being described. In the description of the embodiments of the present disclosure, "plurality" means two or more, unless expressly specified otherwise.

Any reference to "embodiment(s)" herein means that particular features, structures, or characteristics described in combination with the embodiment(s) may be included in at least one embodiment of the present disclosure. A phrase appearing in various places in the specification does not necessarily refer to the same embodiment, nor is an independent or alternative embodiment mutually exclusive with other embodiments. It is explicitly and implicitly understood by those skilled in the art that the embodiments described herein may be combined with other embodiments.

In the description of embodiments of the present disclosure, the term "and/or" represents merely an association relationship describing associated objects, indicating that there may be three types of relationships, for example, A and/or B, which means three possible cases, that is, the existence of A alone, the existence of both A and B, and the existence of B alone. In addition, the character "/" herein generally indicates that the associated objects are in an "or" relationship.

In the description of embodiments of the present disclosure, the term "a plurality of" means two or more (including two). Similarly, the term "a plurality of groups" means two or more groups (including two groups), and the term "a plurality of pieces" means two or more pieces (including two pieces).

In the description of the present disclosure, the terms "center", "longitudinal", "lateral", "length", "width", "thickness", "upper", "lower", "front", "rear", "left", "right", "vertical", "horizontal", "top", "bottom", "inner", "outer", "clockwise", "counterclockwise", "axial", "radial", "circumferential" and other indicated orientations or positional relationships are based on the orientations or positional relationships shown in the accompanying drawings, and are only for the convenience of describing the embodiments of the present disclosure and simplifying the description, rather than indicating or implying that indicated devices or elements must have a particular orientation, be constructed and operate in a particular orientation and are therefore not to be construed as limitations to the embodiments of the present disclosure.

In the description of the embodiments of present disclosure, it should be noted that, unless otherwise explicitly specified and defined, the technical terms "mounting", "connecting" and "connection" should be understood in a broad sense, for example, they may be a fixed connection, a detachable connection, or an integrated connection; may be a mechanical connection, or an electrical connection; and may be a direct connection, or an indirect connection via an intermediate medium, or communication inside two elements. For those of ordinary skill in the art, specific meanings of the above terms in the embodiments of the present disclosure could be understood according to specific circumstances.

In the drawings corresponding to the embodiments of the present disclosure, for better understanding and ease of illustration, the thicknesses and sizes of layers are enlarged. When describing that a component (such as a layer, film, region, or substrate) is referred to as being "on" another component or "on a surface of another component", the component may be directly on the surface of the other component, or a third component may be disposed between the two components. Conversely, when one component is described as being on the surface of another component, or that one component is describe as being formed or disposed on the surface of another component, it indicates that no third component exists between the two components. Furthermore, when a component is referred to as being "substantially formed on" another component, it means that the component is not formed over the entire surface (or front surface) of the other component, nor merely on a portion of an edge thereof.

In the description of the embodiments of the present disclosure, when a certain component is referred to as "including" another component, unless otherwise specified, it does not exclude the presence of other components, and such other components may also be included. Furthermore, when a component such as a layer, film, region, or plate is referred to as being "on" or "formed on" another component, it may be "directly on" the other component (that is, formed on a surface of the other component with no other components in between), or there may be other components interposed between them. Moreover, when a layer, film, region, or plate is "directly on" another component, or when a layer, film, region, or plate is formed on the surface of another component, it indicates that no other components are present between them.

The terminology used in the description of the various embodiments herein is intended solely to describe specific embodiments and is not intended to be limiting. As used in the description of the various embodiments and in the appended claims, the singular forms are intended to include the plural forms, unless the context clearly dictates otherwise. The component includes, but is not limited to, a layer, a film, a region, or a plate.

The embodiments of the present disclosure will be described in detail below with reference to accompanying drawings. However, those of ordinary skill in the art may understand that in each embodiment of the present disclosure, many technical details have been put forward in order to make readers better understand the present disclosure. Nevertheless, even without these technical details and various changes and modifications based on the embodiments below, technical solutions to be protected according to the embodiments of the present disclosure may be substantially implemented.

Some embodiments of the present disclosure provide a solar cell. The solar cell will be described in detail below with reference to the accompanying drawings.

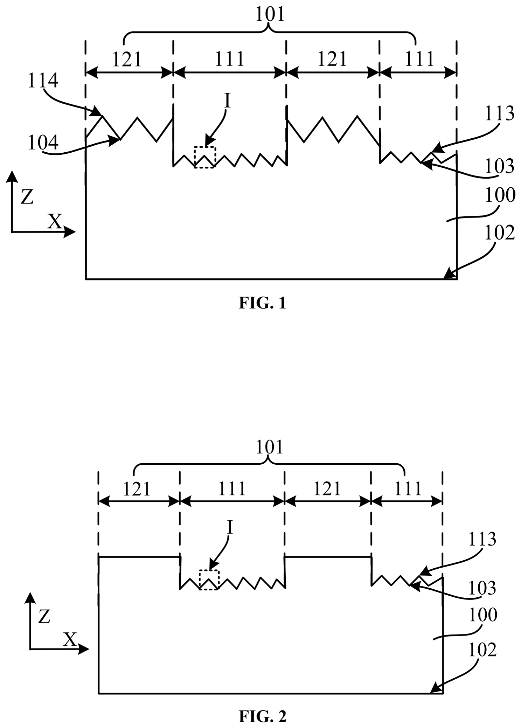

Referring to FIGS. 1-6, the solar cell includes a substrate 100. The substrate 100 includes a first surface 101 and an opposing second surface 102. The first surface 101 includes a first region 111 and a second region 121 alternately formed along a first direction X. The first region 111 has a first textured surface 103, and the first textured surface 103 includes a plurality of first pyramids 113. Each first pyramid of at least some of the plurality of first pyramids 113 includes a main body portion 123 and at least two enclosing portions 133 formed on a lateral surface 123a of the main body portion 123 and connected along a direction perpendicular to the lateral surface 123a. The main body portion 123 is a pyramid-like structure having a plurality of lateral edges 123b, the lateral surface 123a is connected to adjacent lateral edges 123b, and the main body portion 123 further includes a bottom surface 123c connecting a plurality of lateral surfaces 123a. A respective enclosing portion of the enclosing portions 133 extends toward the bottom surface 123c along a second direction Y different from the first direction X. A protruding block 143 is formed at an end of the respective enclosing portion 133 away from the bottom surface 123c, where the protruding block 143 protrudes relative to the bottom surface 123c. In some embodiments, the second direction Y corresponds to an extending direction of the lateral edge 123b.

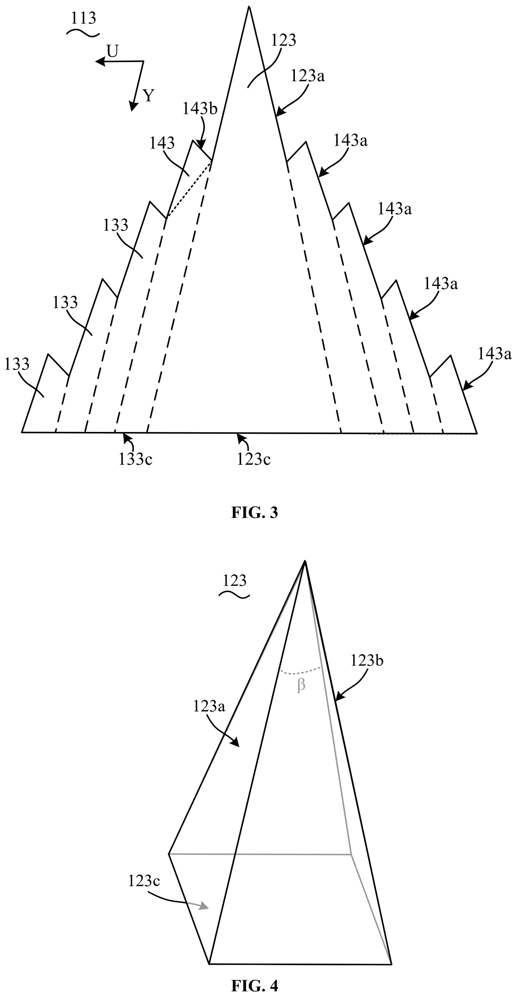

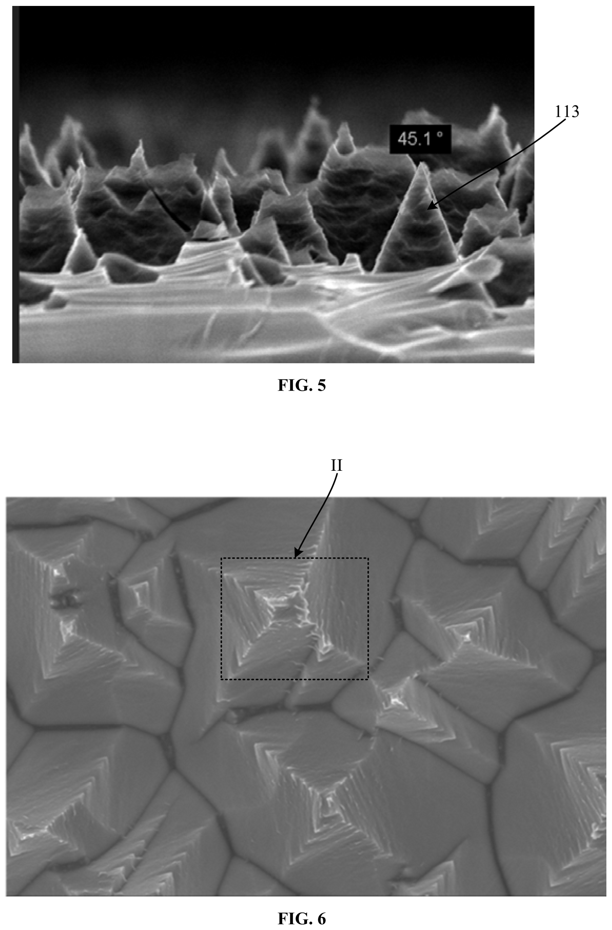

It should be noted that FIG. 1 is a first schematic diagram of a partial sectional view of a solar cell according to some embodiments of the present disclosure; FIG. 2 is a second schematic diagram of a partial sectional view of a solar cell according to some embodiments of the present disclosure; FIG. 3 is an enlarged schematic diagram of the dashed box I in FIG. 1 or 2; FIG. 4 is a schematic diagram of a perspective view of the main body portion shown in FIG. 3; FIG. 5 is a perspective view of a scanning electron microscope (SEM) of a first region of a solar cell according to some embodiments of the present disclosure; and FIG. 6 is a schematic diagram of a top view of a first region of a solar cell according to some embodiments of the present disclosure.

In addition, first, to clearly illustrate the main body portion 123 and the enclosing portions 133 in the first pyramid 113, approximate areas occupied by the main body portion 123 and the enclosing portions 133 in the first pyramid 113 are depicted in thick dashed lines in FIG. 3; second, to clearly illustrate the protruding block 143 in the enclosing portion 133, an approximate area occupied by the protruding block 143 in an enclosing portion 133 is depicted in a thinner dashed line in FIG. 3; third, to highlight the enclosing portions 133 in FIG. 3, the enclosing portions 133 are drawn larger; however, in practical applications, the enclosing portions 133 are smaller those shown in FIG. 3 relative to the main body portion. For example, in a direction perpendicular to the lateral surfaces of the main body portion, the enclosing portion has a thinner thickness. Accordingly, an apex angle of the first pyramid 113 may be regarded as an apex angle of the main body portion 123; and fourth, to clearly illustrate an apex angle size of one first pyramid 113, a contour of the first pyramid 113 is outlined in green lines, and a green annotation is employed to indicate that the apex angle of the first pyramid 113 is 45.1° in FIG. 5.

It is noted that a surface of the first pyramid 113 according to some embodiments of the present disclosure is designed to be rougher than that of a conventional pyramid. Specifically, the surface of the first pyramid 113 is enclosed layer-by-layer by a plurality of enclosing portions 133. An enclosing portion 133 includes a protruding block 143 raised relative to a bottom surface 123c, such that the surface of the first pyramid 113 has a plurality of protruding blocks 143, a surface roughness of the first pyramid 113 is greatly increased, thereby enhancing a light-trapping effect of the first pyramid 113 on incident light. Consequently, a reflectivity of the first textured surface 103 including rough-surfaced first pyramids 113 is further reduced, allowing a second region 121 to absorb more light and generate more charge carriers. This effectively increases the open-circuit voltage and short-circuit current of the solar cell, and improves the photovoltaic conversion efficiency of the solar cell.

It should be noted that, to clearly illustrate a surface morphology of the first pyramid 113, the first pyramid 113, for those skilled in the art, the first pyramid 113 may be divided into the main body portion 123 and at least two enclosing portions 133 formed on a lateral surface 123a of the main body portion 123 and connected along a direction perpendicular to the lateral surface 123a. The main body portion 123 is a pyramid-like structure having a plurality of lateral edges 123b, the lateral surface 123a is connected to adjacent lateral edges 123b. For example, referring to FIG. 4, the main body portion 123 may be regarded as a quadrangular pyramid structure having four relatively smooth lateral surfaces 123a. Based on the main body portion 123, the enclosing portions 133 are designed on the lateral surfaces 123a. Each lateral surface 123a is enclosed by at least two layers of enclosing portions 133, in other words, at least two layers of the enclosing portions 133 are stacked in the direction perpendicular to the lateral surface 123a.

Moreover, not only is partial surface of the main body portion 123 enclosed by the enclosing portions 133, but portions of the surfaces of the enclosing portions 133 nearer the main body portion 123 are also partially enclosed by other enclosing portions 133 farther away from the main body portion 123. On any lateral surface 123a, along a direction U from the main body portion 123 toward the enclosing portions 133, an extending length of at least two layers of the enclosing portion 133 along the second direction Y decreases layer by layer, such that each of the enclosing portions 133 has a portion not enclosed by the other enclosing portion 133, that is, the protruding block 143 at an end of the enclosing portion 133 away from the bottom surface 123c.

In some embodiments, compared with the reflectivity of conventional pyramid-textured surfaces, the reflectivity of the first region 111 of the solar cell according to some embodiments of the present disclosure can be further reduced by 3%-4%. For example, the first region 111 is designed as the first textured surface 103, and the first textured surface 103 includes a plurality of rough-surfaced first pyramids 113, which facilitates reducing the reflectivity of the first region 111 to below 7%, for example, the reflectivity of the first region 111 is 6.84%, 6.7%, or 6.37%. Furthermore, compared with the light reflectivity of conventional pyramid-textured surfaces, the first region 111 is designed as the first textured surface 103 having a plurality of rough-surfaced first pyramids 113 helps increase the overall short-circuit current of the solar cell by approximately 80 mA.

Furthermore, the solar cell according to some embodiments of the present disclosure also helps increase an open-circuit voltage to 0.74 V or higher, and a short-circuit current of the solar cell to 14 A or higher, thereby enabling the photovoltaic conversion efficiency of the solar cell to reach 26.8% or above.

It is worth emphasizing that the solar cell further includes at least one electrode disposed on the first surface 101. The electrode is configured to extract photogenerated charge carriers generated in the substrate 100. A roughness of the region in the first surface 101 directly opposite the electrode needs to be reduced to improve a thickness uniformity of the film layer formed in the region, thereby reducing surface state defects in the region and minimizing metal recombination between the electrode and the region. Therefore, only a portion of the first surface 101 is designed as the first textured surface 103 having a plurality of rough-surfaced first pyramids 113.

Accordingly, for ease of describing a specific location of the first pyramids 113 on the first surface 101, those skilled in the art will readily understand that the first surface 101 may be divided into a second region 121 and a first region 111. Specifically, the second region 121 at least includes an area where an orthographic projection of the electrode on the substrate 100 is located, while the area on the first surface 101 other than the second region 121 is defined as the first region 111. To ensure that the film layer contacted by the electrode has a high doping concentration or that a region contacted by the electrode is highly doped to reduce a contact resistance, an orthographic projection area of the second region 121 is generally designed to be greater than or equal to an orthographic projection area of the electrode. In other words, the area of the orthographic projection of the electrode on the substrate 100 is smaller than the area of the orthographic projection of the second region 121, and an orthographic projection must be located within the second region 121. It is noted that a plurality of second regions 121 and a plurality of first regions 111 may be provided. The second regions 121 and the first regions 111 are alternately formed along the first direction X; in other words, each second region 121 may be formed between two adjacent first regions 111, and each first region 111 may be formed between two adjacent second regions 121. It is noted that in the solar cell provided in the embodiments of the present disclosure, the first region 111 also functions or is referred to as a non-metallization region, and the second region 121 also functions or is referred to as a metallization region.

Embodiments of the present disclosure will be further described in detail below in conjunction with the accompanying drawings.

In some embodiments, referring to FIGS. 3-5, the protruding block 143 includes an extension surface 143a extending toward the bottom surface 123c along the second direction Y, and a step surface 143b connecting the main body portion 123 and the extension surface 143a, or connecting adjacent extension surfaces 143a. An angle between the step surface 143b and the second direction Y is less than or equal to 90°.

It is worth noticing that, for an enclosing portion 133 nearest the main body portion 123, the protruding block 143 of the enclosing portion 133 and the main body portion 123 define a first minor groove recessed toward the bottom surface 123c. The first minor groove may also be regarded as being formed by the step surface 143b of the protruding block 143 and the lateral surface 123a of the main body portion 123. For an enclosing portion 133 that is not in direct contact with the main body portion 123 but is in direct contact with another enclosing portion 133, the protruding block 143 of the enclosing portion 133 and the protruding block 143 of the other enclosing portion 133 define a second minor groove recessed toward the bottom surface 123c. The second minor groove may also be regarded as being formed by the step surface 143b of one of the adjacent protruding blocks 143 and the extension surface 143a of the other protruding block 143.

In other words, in addition to an apex of the main body portion 123 away from the bottom surface 123c, each single first pyramid 113 is provided with a plurality of protruding blocks 143 raised relative to the bottom surface 123c. As a result, the lateral surfaces of the first pyramid 113 are provided with the first minor groove and the second minor groove. Light incident on either the first minor groove or the second minor groove creates more reflection or refraction angles, such that the light is easier to be absorbed by the first pyramid 113 within the enclosure of the first minor groove or the second minor groove after undergoing several times of reflections or refractions to reduce the probability of light being reflected beyond the first pyramid 113. This facilitates enhancing the light-trapping effect of the first pyramid 113, and improving the photovoltaic conversion efficiency of the solar cell.

In some embodiments, referring to FIGS. 3 and 5, the step surface 143b may be a curved surface. In practice, the step surface 143b may also be a substantially flat surface. Herein, "substantially" refers to that a step surface 143b is not a perfectly flat surface, but has a roughness to some degree, for example a roughness within a preset flatness tolerance.

It should be noted that the step surface 143b may be regarded as a surface extending as a whole in a direction away from the lateral surface 123a of the main body portion 123. The surface may be approximately planar or approximately curved, where the term "approximately" indicates that the surface may have a certain degree of roughness. In other words, an intersection between the step surface 143b and the lateral surface 123a of the main body portion 123 can appear as a straight line or a curve. Furthermore, the step surface 143b is a surface observable under a scanning electron microscope (SEM), and under SEM imaging, the step surface 143b is approximately planar or approximately curved. Moreover, for different protruding blocks 143 with different stepped surfaces 143b, some step surfaces 143b may be curved while other step surfaces 143b may be planar.

In one example, the intersection between the step surface 143b and the lateral surface 123a of the main body portion 123 forms a curved line, which may be a wavy line. In this case, the step surface 143b resembles an uneven "ripple." Specifically, different regions of the step surface 143b extend along different directions, providing more reflection or refraction angles for light incident on the step surface 143b, thereby increasing a total amount of light ultimately absorbed by the first minor groove or the second minor groove.

In some embodiments, a number of step surfaces 143b spaced apart on any lateral surface 123a of the main body portion 123 along the second direction Y may range from three to six. For example, a given lateral surface 123a may be provided with four or five step surfaces 143b spaced apart along the second direction Y. It should be noted that FIG. 3 illustrates an example that the numbers of step surfaces 143b spaced apart on two opposite lateral surfaces 123a of the main body portion 123 along the second direction Y are the same, that is, four step surfaces are arranged on each side surface. In practical applications, the number of step surfaces 143b on different lateral surfaces of the same main body portion 123 may vary.

It is worth noting that, for a given main body portion 123, the number of step surfaces 143b spaced apart on each lateral surface 123a along the second direction Y is related to a size of the main body portion 123. The larger the main body portion 123, the larger the area of the corresponding lateral surface 123a, and the more step surfaces 143b may be spaced apart on the lateral surface 123a along the second direction Y. Specifically, the size of the main body portion 123 mainly consists of an area of the bottom surface 123c of the main body portion 123 and a height of the main body portion 123 along a third direction Z, where the third direction Z corresponds to a thickness direction of the substrate 100.

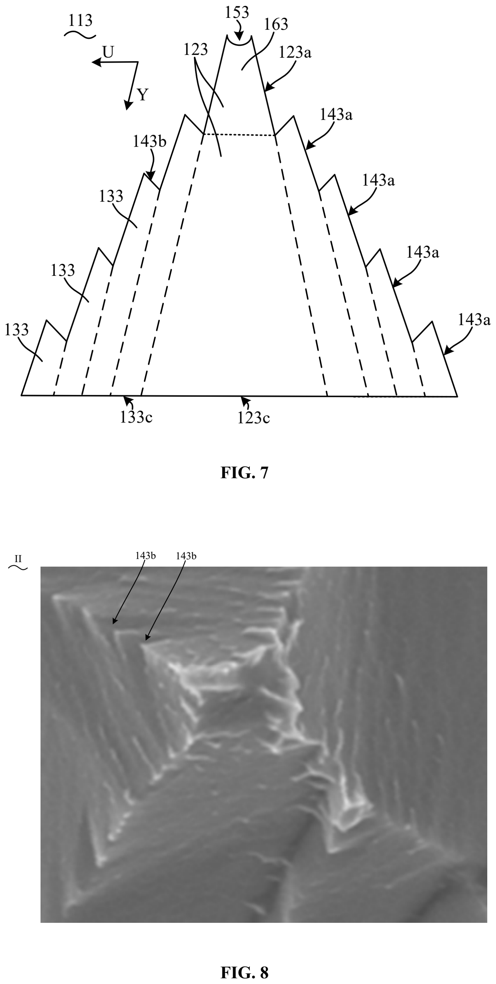

In some embodiments, referring to FIG. 7, FIG. 7 is another enlarged schematic diagram of the dashed box I in FIG. 1 or 2, a portion of the main body portion 123 includes a pit 153 away from the bottom surface 123c. In this way, the surface roughness of the first pyramid 113 may be further increased by the pit 153, such that the light incident on the pit 153 of the first pyramid 113 has more reflection and refraction angles. This allows the light easier to be absorbed by the first pyramid 113 within the enclosure of the pit 153 having reflections or refractions angles, thereby further reducing the probability of light being reflected beyond the first pyramid 113, and enhancing the light-trapping effect of the first pyramid 113, which in turn further improves the photovoltaic conversion efficiency of the solar cell.

It should be noted that, for a main body portion 123 without having a pit 153, referring to FIG. 4, the main body portion 123 may be regarded as a quadrangular pyramid formed by four lateral edges 123b sharing a common vertex and four lateral surfaces 123a connecting adjacent lateral edges 123b. For a main body portion 123 having a pit 153, referring to FIG. 7, the main body portion 123 may be regarded as a quadrangular pyramid with the pit 153 at a vertex. The quadrangular pyramid with the pit 153 at the vertex 163 may be regarded as a quasi-quadrangular pyramid. In other words, due to the presence of the pit 153, endpoints of a plurality of lateral edges 123b (see FIG. 4) do not converge to a same vertex; but the extending directions of the lateral edges 123b can still converge to the same vertex. Based on this, the main body portion 123 may be regarded as a pyramid-like structure having the plurality of lateral edges 123b. The lateral surfaces 123a of the main body portion 123 connect adjacent lateral edges 123b, and the endpoints of the lateral edges 123b may or may not converge at the same vertex. Moreover, only a portion of the main body portions 123 have pits 153 away from the bottom surface 123c; not every main body portion 123 includes a pit 153 at its vertex.

To clearly illustrate the vertex 163 within the main body portion 123, FIG. 7 uses thin dashed lines to delineate an approximate region occupied by the vertex 163 within the main body portion 123.

In some embodiments, referring to FIG. 7, a volume of the pit 153 is defined as a first volume, and a volume of the vertex 163 of the main body portion 123 is defined as a second volume. A ratio of the first volume to the second volume may range from 1/10 to 1/5. For example, the ratio of the first volume to the second volume may be 0.11, 0.12, 0.13, 0.14, 0.15, 0.16, 0.17, 0.18, or 0.19.

It is worth noting that a volume of the pit 153 is relatively small relative to the vertex 163 of the main body portion 123. Based on this, for the first pyramid 113 as a whole, the volume of the pit 153 accounts for only a small proportion of the total volume of the first pyramid, such that the overall appearance of the first pyramid 113 still clearly resembles a pyramid structure, and does not affect the structural stability of the first pyramid 113.

In some embodiments, referring to FIGS. 3, 6, and 8, FIG. 8 is an enlarged schematic diagram of the structure shown in FIG. 6. At least some of the enclosing portions 133 surround the plurality of lateral surfaces 123a of the main body portion 123. In other words, at least some of the enclosing portions 133 may be concurrently formed at the plurality of lateral surfaces 123a of a same main body portion 123. After extending along one given lateral surface 123a, the enclosing portion 133 turns at a side edge 123b, and further extend along another adjacent lateral surface 123a.

It should be noted that FIGS. 6 and 8 illustrate an example where a given enclosing portion 133 (see FIG. 3) concurrently formed on two adjacent lateral surfaces 123a (see FIG. 3) of the main body portion 123 (see FIG. 3). In practical applications, at least some of the enclosing portions 133 may surround three or four lateral surfaces of the main body portion, or an individual enclosing portion may be formed on only one lateral surface of the main body portion. In other words, the number of lateral surfaces of the main body portion surrounded by the enclosing portions in the embodiments of the present disclosure is not limited. Further, an individual enclosing portion 133 has a step surface 143b. An individual step surface 143b may also surround at least one lateral surface 123a of the main body portion 123.

In some embodiments, referring to FIGS. 3 and 5, a number of enclosing portions 133 formed on different lateral surfaces 123a may be the same or different. It is worth noting that an individual enclosing portion 133 may be formed on an individual lateral surface 123a or enclose a plurality of lateral surfaces 123a of the main body portion 123. When calculating the number of enclosing portions 133 on different lateral surfaces 123a, the single enclosing portion 133 that encloses a plurality of lateral surfaces 123a may be regarded as a plurality of portions corresponding one-to-one with each lateral surface 123a, and the number of enclosing portions 133 on each lateral surface 123a is a sum of the number of enclosing portions 133 or the number of the portions of enclosing portions 133 on the lateral surface 123a. In addition, FIG. 3 only illustrates an example where the numbers of enclosing portions 133 spaced apart on two opposite lateral surfaces 123a of the main body portion 123 are the same, that is, four step surfaces are arranged on each side surface. In practical applications, the number of enclosing portions 133 on different lateral surfaces of the same main body portion 123 may vary.

In some embodiments, referring to FIGS. 3 and 5, extending lengths of different enclosing portions 133 on different lateral surfaces 123a may be the same or different along the second direction Y.

In some embodiments, referring to FIGS. 3 and 4, for two adjacent lateral surfaces 123a sharing a lateral edge 123b, the enclosing portions 133 on the adjacent lateral surfaces 123a may be axially and symmetrically distributed along the lateral edge 123b. This helps improve the regularity of the surface morphology of the first pyramid 113, thereby facilitating better adhesion between a film layer subsequently formed on the first textured surface 103 and the surface of the first pyramid 113 and improving the uniformity of the film layer.

In some embodiments, referring to FIG. 3 or FIG. 7, the enclosing portion 133 has an end face 133c near the bottom surface 123c of the main body portion 123. In a same first pyramid 113, the bottom surface 123c and the end faces 133c of the enclosing portions 133 together constitute a base of the first pyramid 113. In other words, the base of the first pyramid 113 is formed by the main body portion 123 and a plurality of enclosing portions 133, which facilitates improving the overall stability of the first pyramid 113 and enhancing the stability of the first textured surface 103.

It should be noted that an entire bottom of the first pyramid 113 may be regarded as the base of the first pyramid 113. An orthographic projection pattern of the base of the first pyramid 113 on the substrate 100 may be a regular quadrangle. In practical applications, the orthographic projection pattern of the base of the first pyramid on the substrate may also be an irregular polygon.

In some embodiments, referring to FIG. 4, an included angle β between two opposite lateral edges 123b of the main body portion 123 may range from 40° to 50°, for example, the included angle may be 40.1°, 40.5°, 40.8°, 41°, 41.1°, 41.5°, 41.8°, 42°, 42.1°, 42.5°, 42.8°, 43°, 43.1°, 43.5°, 43.8°, 44°, 44.1°, 44.5°, 44.8°, 43°, 43.1°, 43.5°, 43.8°, 45°, 45.1°, 45.5°, 45.8°, 46°, 46.1°, 46.5°, 46.8°, 47°, 47.1°, 47.5°, 47.8°, 48°, 48.1°, 48.5°, 48.8°, 49°, 49.1°, 49.5°or 49.8°, and the like.

It is worth noting that the included angle between two opposite lateral edges 123b of the main body portion 123 may be regarded as the apex angle of the first pyramid 113. Compared with the apex angle of surfaces of conventional pyramids that is approximately 70°, for example 60° to 80°, the apex angle of the first pyramid 113 is designed to be smaller. On the one hand, a smaller apex angle increases a number of reflections of light on the first textured surface 103 and extends an optical path, thereby improving the absorptance of light by the first textured surface 103. On the other hand, the first pyramid 113 having a smaller apex angle can more effectively capture incident light, for example, allowing incident light at more angles to be reflected into the first textured surface 103, thereby increasing a total amount of light entering the first textured surface 103. In this way, a plurality of factors work together to enhance the light-trapping effect of the first textured surface 103.

In some embodiments, referring to FIG. 1, the second region 121 may have a second textured surface 104, and the second textured surface 104 includes a plurality of second pyramids 114. In other embodiments, referring to FIG. 2, the second region 121 may have a polished flat surface. It should be noted that the second region 121, as an example, that includes the second textured surface 104 having a plurality of second pyramids 114 will be described below.

It is worth noting that the second textured surface 104 including a plurality of second pyramids 114 is a conventional pyramid-textured surface. In other words, compared with the rough-surfaced first pyramids 113, the surface of the second pyramid 114 is smoother. Accordingly, regardless of whether the second region 121 has a polished flat surface or a second textured surface 104, a surface roughness of the second region 121 is smaller than the surface roughness of the first region 111 having the first textured surface 103. Subsequently, at least other additional functional layer, such as a passivation layer or an electrode, may be formed on the second region 121. The lower surface roughness of the second region 121 facilitates improving the uniformity of the film layer formed on the second region 121, avoiding significant thickness variations across different areas, and allowing for better adhesion between the electrode and the second region 121 or the functional layer, thereby improving the contact performance between the electrode and the second region 121 or the functional layer, and increasing the open-circuit voltage and influence factor of the solar cell. In addition, the first region 111 having the first textured surface 103 helps improve the absorptance of light by the substrate 100, thereby increasing the short-circuit current of the solar cell.

In some embodiments, compared with configuring the second region as a first textured surface, designing the second region as a second textured surface is beneficial for reducing metal recombination between the electrode and the second region 121 or the functional layer, thereby increasing a fill factor of the solar cell by approximately 0.3. In one example, the solar cell according to some embodiments of the present disclosure can increase the fill factor to 86.3 or higher.

In some embodiments, referring to FIGS. 1 and 4, an included angle β between two opposite lateral edges 123b of the main body portion 123 is defined as a first included angle, an included angle between two opposite lateral edges of the second pyramid 114 (not labeled in FIG. 1) is defined as a second included angle, and the second included angle is greater than the first included angle. The lateral edge 123b of the main body portion 123 is regarded as a first lateral edge, and the lateral edge of the second pyramid 114 is regarded as a second lateral edge.

In other cases, referring to FIG. 1, within a same disposition area, a number of second pyramids 114 arranged in the second textured surface 104 is less than the number of first pyramids 113 arranged in the first textured surface 103. In other words, an arrangement density of first pyramids 113 in the first textured surface 103 is higher than an arrangement density of second pyramids 114 in the second textured surface 104. On the one hand, the higher density is advantageous for increasing a total surface area and a specific surface area of the first textured surface 103, providing the first region 111 with more surface area for receiving the incident light, thereby allowing more light to be ultimately absorbed by the first textured surface 103. On the other hand, the higher density facilitates reducing a gap between adjacent first pyramids 113, allowing the first textured surface 103 to capture the incident light more effectively, and reducing the probability of light escaping between the adjacent first pyramids 113. Furthermore, the greater number of first pyramids 113 allows for more uniform distribution of incident light, making the incident light more easily penetrate into the substrate 100 for absorption and utilization. Moreover, the higher density helps reduce the sensitivity of the first region 111 to an incident angle of light, allowing the first region 111 to maintain a high absorptance of light under different illumination angles.

In some embodiments, referring to FIG. 1, the number of first pyramids 113 in the first region 111 ranges from approximately 1953 to 2091, for example, the number of first pyramids may be 1960, 1970, 1980, 1990, 2000, 2010, 2020, 2030, 2040, 2050, 2060, 2070, 2080, or 2090, and the like; and the number of second pyramids 114 in the second region 121 ranges from approximately 1402 to 1472, for example, the number of second pyramids may be 1405, 1410, 1415, 1420, 1425, 1430, 1435, 1440, 1445, 1450, 1455, 1460, 1465, or 1470, and the like.

In some embodiments, referring to FIG. 1, the surface area of the first region 111 having the first textured surface 103 that includes a plurality of first pyramids 113 is approximately 7871 µm²-8812 µm², for example, the surface area may be 7880 µm², 7980 µm², 8080 µm², 8180 µm², 8280 µm², 8380 µm², 8480 µm², 8580 µm², 8680 µm² or 8780 µm², and the like; and the surface area of the second region 121 having the second textured surface 104 that includes a plurality of second pyramids 114 is approximately 7443 µm²-7503 µm², for example, the surface area may be 7450 µm², 7455 µm², 7460 µm², 7465 µm², 7470 µm², 7475 µm², 7480 µm², 7485 µm², 7490 µm², 7495 µm² or 7500 µm², and the like.

In some embodiments, referring to FIG. 1, the specific surface area of the first region 111 in the first textured surface 103 that includes a plurality of first pyramids 113 is approximately 1.346-1.506, for example, 1.35, 1.36, 1.37, 1.38, 1.39, 1.4, 1.41, 1.42, 1.43, 1.44, 1.45, 1.46, 1.47, 1.48, 1.49 or 1.5, and the like; and the specific surface area of the second region 121 in second textured surface 104 that includes a plurality of second pyramids 114 is approximately 1.272-1.283, for example, 1.273, 1.274, 1.275, 1.276, 1.277, 1.278, 1.279, 1.28, 1.281 or 1.282, and the like.

It should be noted that the specific surface area of the first region 111 refers to a ratio of the sum of the surface areas of all first pyramids 113 in a scanning area by the microscope on the first region 111 to an area of a region scanned by the microscope. The region scanned by the microscope on the first region 111 is a plane. Similarly, the specific surface area of the second region 121 refers to a ratio of the sum of the surface areas of all second pyramids 114 in a scanning area by the microscope on the second region 121 to an area of a region scanned by the microscope. The region scanned by the microscope on the second region 121 is a plane.

In some other cases, referring to FIG. 1, a height of the second pyramid 114 may be greater than a height of the first pyramid 113. It is worth noting that, compared with the second pyramid 114, on the one hand, the lower height of the first pyramid 113 facilitates a more uniform distribution of light incident on the first region 111, preventing local light intensity from being too high or too low in the first region 111, thus enhancing overall absorptance of light of the first textured surface 103. Furthermore, it exhibits better absorptance of light than the light incident at an oblique angle relative to the first direction X, thereby better capturing wide-angle incident light and reducing light escape. This further reduces light reflection losses on the first region 111 and improves the photovoltaic conversion efficiency of the solar cell under low-light or oblique-light conditions. On the other hand, the lower height of the first pyramid 113 facilitates the reduction of scattering paths of light on the first region 111 to enhance the absorptance of short-wavelength light, such as absorptance of blue and ultraviolet light, by first textured surface 103. Moreover, the lower height of the first pyramid 113 is advantageous for shortening a transport distance of photogenerated charge carriers in the first textured surface 103, thereby reducing the probability of charge carrier recombination and improving the photovoltaic conversion efficiency of the solar cell.

In some embodiments, referring to FIG. 1, the height of the first pyramid 113 in the first region 111 ranges from approximately 0.8763 µm to 0.9353 µm, for example, 0.877 µm, 0.881 µm, 0.885 µm, 0.89 µm, 0.895 µm, 0.9 µm, 0.905 µm, 0.91 µm, 0.911 µm, 0.915 µm, 0.92 µm, 0.923 µm, 0.925 µm, 0.93 µm, or 0.933 µm. The height of the second pyramid 114 in the second region 121 ranges from approximately 1.109 µm to 1.577 µm, for example, 1.115 µm, 1.12 µm, 1.15 µm, 1.2 µm, 1.25 µm, 1.3 µm, 1.35 µm, 1.4 µm, 1.45 µm, 1.5 µm, 1.55 µm, or 1.56 µm.

It should be noted that, for the first textured surface 103 and the second textured surface 104, the above three scenarios may coexist at the same time, or any one or two of them may be present.

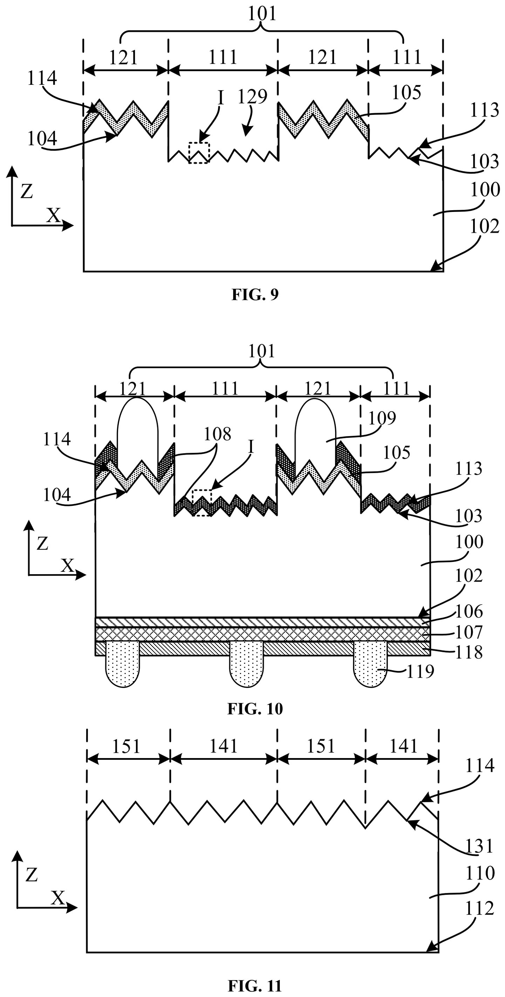

In some embodiments, referring to FIG. 9, the solar cell may further include a first doped semiconductor layer 105 doped with a first dopant, formed on the second region 121; and the substrate 100 in the first region 111 is recessed toward the second surface 102. In other words, taking the second surface 102 as a reference plane, a distance between the first region 111 and the reference plane is smaller than that between the second region 121 and the reference plane. The first region 111 may be regarded as having a groove 129. This configuration is beneficial for not only increasing absorptance of light by the first region 111 through the first textured surface 103 including the first pyramids 113, but also increasing the number of light reflection and/or scattering in the groove 129 in the first region 111, and increasing a surface area of the first region 111 for light absorption, thereby further improving the light-trapping effect.

FIG. 9 is a third partial sectional view of a solar cell according to some embodiments of the present disclosure. The enlarged schematic diagram of the dashed box II shown in FIG. 9 may be similar to that in FIG. 3 or FIG. 7.

In some embodiments, under the condition that the second region 121 has the second textured surface 104 and the first region 111 has the first textured surface 103, the substrate 100 in the first region 111 is designed to be recessed toward the second surface 102. This configuration, compared with a solar cell with a conventional textured surface on the first surface, is beneficial for stabilizing the open-circuit voltage and fill factor, thereby increasing the photovoltaic conversion efficiency of the solar cell by more than 0.1%.

In some embodiments, the first doped semiconductor layer 105 doped with the first dopant is formed on the substrate 100 and in the second region 121. In other words, there is no distinct boundary between the first doped semiconductor layer 105 and the substrate 100 in the second region 121. On this basis, a sidewall of the groove formed by recessing the substrate 100 in the first region 111 toward the second surface 102 may be regarded as being jointly formed by the first doped semiconductor layer 105 and the substrate 100 in the second region 121.

In some embodiments, referring to FIG. 10, the solar cell may further include a tunneling layer 106 formed on the second surface 102; a second doped semiconductor layer 107 doped with a second dopant formed on a side of the tunneling layer 106 away from the second surface 102, where the first dopant and the second dopant have different conductivity types; a first passivation layer 108 formed on a side of the first doped semiconductor layer 105 away from the substrate 100 and on the first region 111; a second passivation layer 118 formed on a side of the second doped semiconductor layer 107 away from the tunneling layer 106; a first electrode 109 embedded in the first passivation layer 108 and in ohmic contact with the first doped semiconductor layer 105; and a second electrode 119 embedded in the second passivation layer 118 and in ohmic contact with the second doped semiconductor layer 107.

FIG. 10 is a fourth partial sectional view of a solar cell according to some embodiments of the present disclosure. The enlarged view of the first pyramid 113 in the dashed box I shown in FIG. 10 may also be similar to that shown in FIG. 3 or 7.

It is worth noting that the tunneling layer 106 and the second doped semiconductor layer 107 together form a passivated contact structure. The tunneling layer 106 chemically passivates the second surface 102, saturates dangling bonds of the second surface 102, reduces a defect state density of the second surface 102, and lowers the probability of charge carrier recombination on the second surface 102. The second doped semiconductor layer 107 performs a field passivation on the second surface 102 to reduce a concentration of minority charge carriers, further reducing the probability of charge carrier recombination and improving the photovoltaic conversion efficiency of the solar cell. In addition, the first passivation layer 108 can passivate the first surface 101 to reduce a defect state density of the first surface 101, and serve as an optical optimization layer of the first surface 101 to improve the light absorption and utilization efficiency on the first surface 101 of the solar cell. The second passivation layer 118 can further passivate the second surface 102 and serve as an optical optimization layer of the second surface 102 to improve the light absorption and utilization efficiency on the second surface 102 of the solar cell. In addition, the first doped semiconductor layer 105 formed only on the second region 121 may serve as a selective emitter structure, which helps reduce a contact resistance between the first electrode 109 and the first doped semiconductor layer 105, and reduce the probability of charge carrier recombination in other regions on the first surface 101.

In some embodiments, the tunneling layer 106 is made of at least one of silicon oxide, silicon nitride, silicon oxynitride, silicon carbide, or magnesium fluoride. The second doped semiconductor layer 107 is made of at least one of amorphous silicon, polycrystalline silicon, or silicon carbide. Both the second doped semiconductor layer 107 and the substrate 100 may be doped with the second dopant.

In some embodiments, the first passivation layer 108 and the second passivation layer 118 may be a single-layer structure or a multi-layer structure. Further, the materials for the first passivation layer 108 and the second passivation layer 118 may include at least one of aluminum oxide, silicon oxide, silicon nitride, or silicon oxynitride.

In some embodiments, the substrate 100 may be made of an elemental semiconductor material. Specifically, the elemental semiconductor material consists of a single element, such as silicon or germanium. The elemental semiconductor material may be in a monocrystalline state, polycrystalline state, amorphous state, or microcrystalline state (a state simultaneously possessing monocrystalline and amorphous states is called microcrystalline). For example, silicon may be at least one of monocrystalline silicon, polycrystalline silicon, amorphous silicon, or microcrystalline silicon. In other cases, the substrate 100 may be a compound semiconductor material. The compound semiconductor material includes, but is not limited to silicon germanium, silicon carbide, gallium arsenide, indium gallium, perovskite, cadmium telluride, or copper indium selenide, and the like.

In some embodiments, the substrate 100 may be an N-type semiconductor substrate, in which case, the second dopant in the second doped semiconductor layer 107 is an N-type dopant, and the first dopant in the first doped semiconductor layer 105 is a P-type dopant. In other cases, the substrate 100 may be a P-type semiconductor substrate, in which case, the second dopant in the second doped semiconductor layer 107 is a P-type dopant, and the first dopant in the first doped semiconductor layer 105 is an N-type dopant.

Specifically, the N-type dopant may be at least one of Group V elements, such as phosphorus (P), bismuth (Bi), antimony (Sb), or arsenic (As). The P-type dopant may be at least one of Group III elements, such as boron (B), aluminum (Al), gallium (Ga), or indium (In).

In summary, the surfaces of the first pyramids 113 in the second region 121 are designed to be rougher than that of conventional pyramids. Specifically, a surface of an individual first pyramid 113 is enclosed layer-by-layer by a plurality of enclosing portions 133. A protruding block 143 raised relative to a bottom surface 123c is formed at an end of a respective enclosing portion of the enclosing portions 133, such that the surface of the first pyramid 113 has a plurality of protruding blocks 143, a surface roughness of the first pyramid 113 is greatly increased, thereby enhancing the light-trapping effect of the first pyramid 113 on incident light. Consequently, a reflectivity of the first textured surface 103 including rough-surfaced first pyramids 113 is further reduced, allowing the second region 121 to absorb more light and generate more charge carriers. This effectively increases the short-circuit current and improves the photovoltaic conversion efficiency of the solar cell.

Some embodiments of the present disclosure provide a method for manufacturing solar cells, which are used for manufacturing the photovoltaic module provided in any of the foregoing embodiments. The method according to some embodiments of the present disclosure will be further described in detail below in conjunction with the accompanying drawings. FIGS. 11-15 illustrate schematic diagrams of partial cross-sectional structures corresponding to each operation of the method according to some embodiments of the present disclosure. It should be noted that description identical or corresponding to the previous embodiments are not repeated in detail herein.

Referring to FIGS. 1-8, and FIGS. 11-15, the method for manufacturing the solar cell includes at least the following operations:

At S1: referring to FIG. 11, FIG. 11 is a schematic diagram of a partial sectional view of an initial substrate provided in a method for manufacturing a solar cell according to some embodiments of the present disclosure. An initial substrate 110 is provided. The initial substrate 110 includes an initial first surface 131 and an initial second surface 112 arranged opposite each other. The initial first surface 131 includes initial first regions 141 and initial second regions 151 alternately formed along a first direction X.

It is worth noting that the initial first surface 131 corresponds to a subsequently formed first surface; the initial first region 141 corresponds to a first region of the subsequently formed first surface; the initial second region 151 corresponds to the second region of the subsequently formed first surface; and the initial second surface 112 corresponds to a subsequently formed second surface.

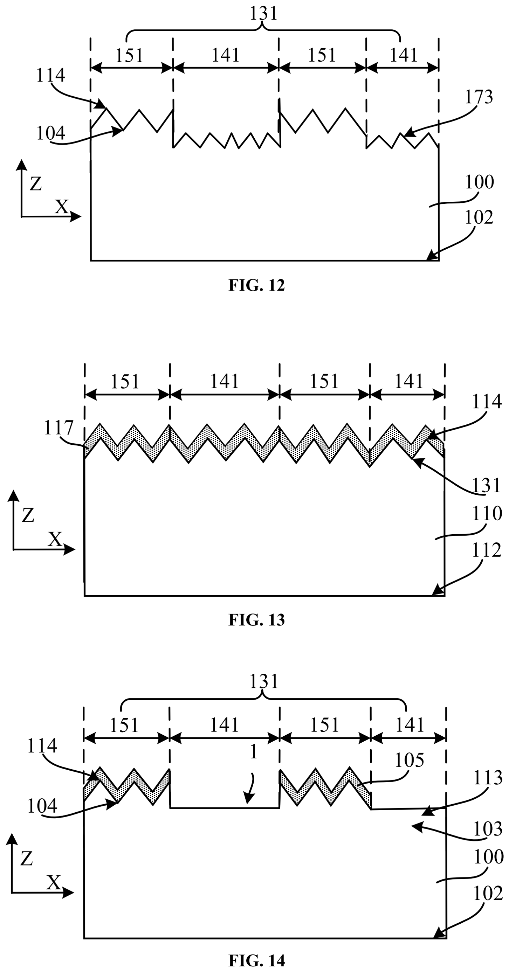

At S2: Referring to FIGS. 11 and 12, or referring to FIG. 11 and FIGS. 13-15, a first texturing treatment is performed on the initial first region 141 using a first etching solution containing a first additive to form a plurality of initial first pyramids 173, where the first additive is used to slow down an etching rate of the initial substrate 110 during the first texturing treatment.

It should be noted that FIG. 12 is a schematic diagram of a partial sectional view of the structure shown in FIG. 11 after the first texturing treatment, and FIG. 1 may be regarded as a schematic diagram of a partial sectional view of the structure shown in FIG. 12 subjected to a second texturing treatment. Furthermore, FIGS. 13-15 will be described in detail in subsequent text.

It is worth noting that the first additive is used to slow down an etching rate of the initial substrate 110 during the first texturing treatment, which is mainly reflected in the reduction of an etching rate of the first etching solution on the crystal planes of the material constituting the substrate 100. On this basis, adding the first additive to the first etching solution further facilitates the formation and growth protection of the pyramids, thereby improving the pyramid growth efficiency while forming sharper pyramid apexes, that is, lowering the apex angle of the formed initial first pyramids 173, so as to eventually form a first pyramid with a smaller apex angle. In addition, compared with the arrangement density of pyramids achieved by a conventional texturing treatment, the addition of the first additive helps increase the arrangement density of the initial first pyramids 173 in the first region 111, in other words, it is beneficial for forming more initial first pyramids 173 in the first region 111.

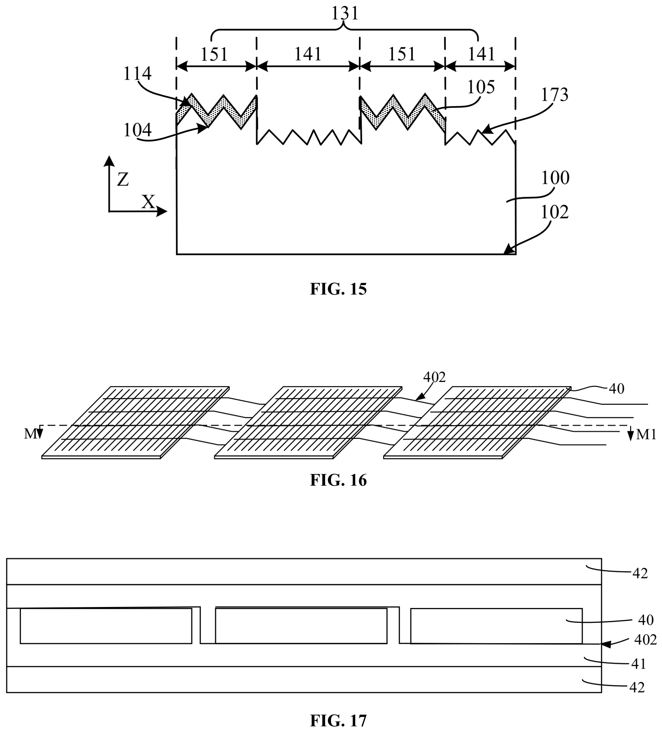

At S3: Referring to FIGS. 12 and 1, or referring to FIGS. 15 and 9, a second texturing treatment is performed on the initial first region 141 using a second etching solution containing a second additive. During the second texturing treatment, the second additive is adsorbed onto at least portions of the surfaces of the plurality of initial first pyramids 173, and the portions of the surfaces of the plurality of initial first pyramids 173 with the second additive function as a protected region. The second additive is used to slow down an etching rate of the protected region during the second texturing treatment, so as to convert the initial first region 141 into a first region 111 having a first textured surface 103. The first textured surface 103 includes a plurality of rough-surfaced first pyramids 113, the remaining initial substrate 110 becomes the substrate 100, the initial second region 151 becomes the second region 121 of the substrate 100, and the initial second surface 112 becomes the second surface 102 of the substrate 100.

In some embodiments, referring to FIGS. 3-8, each first pyramid of at least some of the plurality of first pyramids 113 includes a main body portion 123 and at least two enclosing portions 133 formed on a lateral surface 123a of the main body portion 123 and stacked along a direction perpendicular to the lateral surface 123a. The main body portion 123 is a pyramid-like structure having a plurality of lateral edges 123b, the lateral surface 123a is connected to adjacent lateral edges 123b, and the main body portion 123 further includes a bottom surface 123c connecting a plurality of lateral surfaces 123a. Each enclosing portion 133 extends toward the bottom surface 123c along a second direction Y. An end of the enclosing portion 133 away from the bottom surface 123c includes a protruding block 143, where the protruding block 143 protrudes relative to the bottom surface 123c. In some embodiments, the second direction Y corresponds to an extending direction of the lateral edge 123b.

It is worth noting that, to form the rough-surfaced first pyramids 113, the surfaces of the initial first pyramids 173 formed in operation S2 need to be deeply modified. Based on the adsorption effect of the second additive in the second etching solution provided in the operation S3, partial surfaces of the initial first pyramids 173 is protected by the second additive. This increases a difference in etching rate among different surfaces of the initial first pyramids 173 during the second texturing treatment, and achieves selective etching of the surfaces of the initial first pyramids 173, such that the surfaces of the initial first pyramids 173 not adsorbed with the second additive are etched until it is recessed relative to the surfaces of the initial first pyramids 173 adsorbed with the second additive, thereby ultimately forming a first pyramid 113 with the surfaces having the enclosing portion 133. In other words, the second additive is adsorbed onto partial surfaces of the enclosing portions 133; therefore, as the second texturing treatment progresses, the enclosing portions 133 gradually protrude from the lateral surfaces 123a of the main body 123. The etching rate of the second texturing treatment on the surfaces between adjacent enclosing portions 133 is relatively faster, thus ultimately forming a second minor groove between adjacent enclosing portions 133. Similarly, compared with the etching rate of the second texturing treatment on the regions in the enclosing portions 133 near the main body portion 123, and the etching rate of the second texturing treatment in the region where the apex of the main body portion is located is higher, thereby forming a first minor groove between the enclosing portion 133 and the apex of the main body portion 123.

It should be noted that the surfaces of the initial first pyramids 173 adsorbed with the second additive serve as the protected regions, and the second additive is used to slow down an etching rate of the protected region during the second texturing treatment, which is mainly reflected in the following: the second additive makes the etching rate of the protected regions lower than that of the surfaces excluding the protected regions of the initial first pyramids 173, thereby achieving selective etching of the surfaces morphology of the initial first pyramids 173. In this way, the ultimately formed surface of the first pyramid 113 has a plurality of protruding blocks 143, a surface roughness of the first pyramid 113 is greatly increased, thereby enhancing a light-trapping effect of the first pyramid 113 on incident light. Consequently, a reflectivity of the first textured surface 103 including rough-surfaced first pyramids 113 is further reduced, allowing a second region 121 to absorb more light and generate more charge carriers. This effectively increases the short-circuit current and improves the photovoltaic conversion efficiency of the solar cell.

In some embodiments, a material of the first additive may include a cellulose active agent, where the cellulose active agent contains carboxyl and aldehyde groups; and a material of the second additive includes a surface ionic active agent.

It is worth noting that, on the one hand, the carboxyl and aldehyde groups contained in the cellulose active agent facilitate a uniform etching rate over the entire crystal plane of the substrate material 100, thereby reducing an etching amount at the apex of the preliminarily formed pyramid and slowing down the rate at which the apex of the preliminarily formed pyramid is gradually lowered. This facilitates forming an initial first pyramid 173 with a smaller apex angle across the entire crystal surface, ultimately facilitating the formation of a first pyramid with an even smaller apex angle. On the other hand, during the second texturing treatment, the surface ionic active agent contained in the second additive may be selectively adsorbed onto partial surfaces of the initial first pyramid 173, thereby suppressing the corrosion of the portion of the surfaces by the second etching solution, altering the etching rate of the second etching solution on such surfaces, and thus forming a first pyramid 113 with the surfaces having the enclosing portion 133.

It is worth emphasizing that the primary function of the first additive is to increase a rate of pyramid formation and to modify the entire surface of the initially formed pyramid, so as to form an initial first pyramid 173 having an apex angle smaller than that of a pyramid formed by a conventional texturing treatment, thereby increasing a number of initial first pyramids 173 that can be formed within the first region 111. The primary function of the second additive is to enable selective etching of the surfaces of the initial first pyramid 173, that is, to modify partial surfaces of the initial first pyramid 173, thereby forming a first pyramid 113 with a higher surface roughness.

In some embodiments, referring to FIG. 12 or 15, an included angle between two opposite lateral edges of the initial first pyramid 173 is 50°-60°, where the lateral edges of the initial first pyramid 173 may be regarded as third lateral edges. An included angle between two opposite lateral edges of the initial first pyramid 173 may be regarded as the apex angle of the initial first pyramid 173. In other words, the apex angle of the initial first pyramid 173 may range from 50° to 60°, for example, it may be 50.1°, 50.5°, 50.8°, 51°, 51.1°, 51.5°, 51.8°, 52°, 52.1°, 52.5°, 52.8°, 53°, 53.1°, 53.5°, 53.8°, 54°, 54.1°, 54.5°, 54.8°, 53°, 53.1°, 53.5°, 53.8°, 55°, 55.1°, 55.5°, 55.8°, 56°, 56.1°, 56.5°, 56.8°, 57°, 57.1°, 57.5°, 57.8°, 58°, 58.1°, 58.5°, 58.8°, 59°, 59.1°, 59.5° or 59.8°, and the like. It is worth noting that, the apex angle of pyramids formed through the conventional texturing treatment is approximately 60°-80°, the initial first pyramid 173 has a smaller apex angle, and is formed using the first etching solution containing the first additive to perform a first texturing treatment on the initial first region 141 according to the manufacturing method provided in some embodiments of the present disclosure. Further, in the subsequent operation, a second texturing treatment is performed on the initial first region 141 using a second etching solution containing the second additive, such that the first pyramid 113 formed accordingly has an even smaller apex angle, effectively enhancing the light absorption and utilization efficiency of the finally formed second region 121.

It should be noted that the apex angle of the first pyramid 113 corresponds to the included angle between two opposite lateral edges 123b of the main body portion 123 of the first pyramid 113. In some embodiments, an included angle between two opposite lateral edges 123b of the main body portion 123 of the first pyramid 113 is in a range from 40° to 50°.

In some embodiments, referring to FIG. 12 and FIG. 1, or referring to FIG. 15 and FIG. 9, the adsorption of the second additive onto the partial surfaces of the initial first pyramids 173 during the second texturing treatment exhibits a degree of randomness, the finally resulting first pyramid 113, as shown in FIG. 3 or FIG. 7, may have a step surface 143b nearest the bottom surface 123c of the main body portion 123 that may be infinitely close to the bottom surface 123c. Moreover, a distance between the step surface 143b nearest the bottom surface 123c of the main body portion 123 and the bottom surface 123c may vary among different first pyramids 113.

In some embodiments, referring to FIG. 11, the initial first surface 131 has a second textured surface. The second textured surface includes a plurality of second pyramids 114. After the initial substrate 110 is provided and before the first texturing treatment is performed, the method for manufacturing the solar cell may further include, referring to FIG. 13, forming a first doped semiconductor film 117 doped with a first dopant on the initial first surface 131. Referring to FIGS. 13 and 14, a laser processing is performed on the first doped semiconductor film 117 and the initial substrate 110 in the initial first region 141 to remove the first doped semiconductor film 117 in the initial first region 141 and the second pyramids 114 in the initial first region 141, such that portions of the initial substrate 110 in the initial first region 141 are recessed toward the initial second surface 112. The remaining portions of the first doped semiconductor film 117 in the initial second region 151 serve as the first doped semiconductor layer 105.

FIG. 13 is a schematic diagram of a partial sectional view illustrating a stage after formation of a first doped semiconductor film in a method for manufacturing a solar cell according to some embodiments of the present disclosure; FIG. 14 is a schematic diagram of a partial sectional view of the structure shown in FIG. 13 after laser processing; FIG. 15 is a schematic diagram of a partial sectional view of the structure shown in FIG. 14 after a first texturing treatment; and FIG. 9 is a schematic diagram of a partial sectional view of the structure shown in FIG. 15 after a second texturing treatment.

It is worth noticing that, referring to FIGS. 11 and 9, the initial first surface 131 including a plurality of second pyramids 114 is first formed, ensuring that the second region 121 of the finally formed substrate 100 is a second textured surface 104 including a plurality of second pyramids 114. On this basis, the first doped semiconductor layer 105 can ultimately conformally cover the second textured surface 104 to improve the light absorption and utilization efficiency of the second region 121. In addition, the laser processing is employed to pattern the first doped semiconductor film 117, which, on the one hand, removes the first doped semiconductor film 117 in the initial first region 141 while simultaneously removing the second pyramids 114 in the initial first region 141. This facilitates subsequent first texturing treatment on a relatively smooth surface using a first etching solution containing a first additive to form an initial first pyramid 173 having a small apex angle. On the other hand, the laser processing facilitates the formation of an initial groove in the initial substrate 110 in the initial first region 141. After a differential stepped structure is formed on the initial first surface 131, a first texturing treatment and a second texturing treatment are then performed to form the groove in the first region 111 of the finally formed substrate 100. Moreover, a surface of the groove includes a plurality of first pyramids 113 to increase the number of reflections and/or scatterings of light in the first region 111 and increases a surface area available for absorbing the light, further enhancing the light-trapping effect.

In some embodiments, referring to FIG. 11, a third texturing treatment may be used to process the initial first surface 131, thereby forming a textured surface structure including a plurality of second pyramids 114.

In some embodiments, referring to FIGS. 9 and 10, the method may further include: forming a tunneling layer 106 on the second surface 102; forming a second doped semiconductor layer 107 doped with a second dopant, the second doped semiconductor layer 107 formed on a side of the tunneling layer 106 away from the second surface 102, where the first dopant and the second dopant have different conductivity types; forming a first passivation layer 108, the first passivation layer 108 formed on a side of the first doped semiconductor layer 105 away from the substrate 100 and on the first region 111; forming a second passivation layer 118, the second passivation layer 118 formed on a side of the second doped semiconductor layer 107 away from the tunneling layer 106; forming a first electrode 109, the first electrode 109 embedded in the first passivation layer 108 and in ohmic contact with the first doped semiconductor layer 105; and forming a second electrode 119, the second electrode 119 embedded in the second passivation layer 118 and in ohmic contact with the second doped semiconductor layer 107.

In some embodiments, referring to FIG. 10, the first passivation layer 108 and the second passivation layer 118 may be formed by a plasma-enhanced chemical vapor deposition (PECVD) process. A structure on the substrate 100 with the first doped semiconductor layer 105, the tunneling layer 106, and the second doped semiconductor layer 107 is taken as a target structure. During the PECVD process, the target structure is placed in a graphite boat, and a number of contact locking points between the graphite boat and the target structure are greater than or equal to five.

It is worth noting that increasing the number of contact locking points between the graphite boat and the target structure facilitates increasing a contact area between the graphite boat and the target structure, such that an effective discharge power of the plasma exciter is increased, and a discharge uniformity of the plasma exciter is improved, which in turn facilitates an increase in deposition rate and improves a density of the formed passivation layer, thereby improving the passivation effect on the substrate 100. The passivation layer includes at least one of the first passivation layer 108 or the second passivation layer 118.

In some embodiments, the target structure has four sequentially connected sides. One set of two opposite sides has at least two spaced contact locking points with the graphite boat, and one of the other set of two opposite sides has at least one contact locking point with the graphite boat. It is worth noting that three of the four sides of the target structure have contact locking points; the remaining one side without a contact locking point corresponds to an opening direction of boat plate of the graphite boat, facilitating loading and unloading of the target structure.

In an example, the target structure has four sequentially connected sides. One set of two opposite sides has two spaced contact locking points with the graphite boat, and one of the other set of two opposite sides has one contact locking point with the graphite boat. Two contact locking points on the same side are located at one-fourth of the side from each end, and one contact locking point on the other side is located at a midpoint of the other side. This configuration provides uniform support for the target structure via five contact locking points.

In some embodiments, referring to FIG. 10, the first passivation layer 108 and the second passivation layer 118 may have a stacked structure including an aluminum oxide layer (not shown in the drawings) and an anti-reflection layer (not shown in the drawings). In the first passivation layer 108, the aluminum oxide layer is formed between the first doped semiconductor layer 105 and the anti-reflection layer, and between the first region 111 and the anti-reflection layer. In the second passivation layer 118, the aluminum oxide layer is formed between the second doped semiconductor layer 107 and the anti-reflection layer.

In some embodiments, the material of the anti-reflection layer may include at least one of silicon oxide, silicon nitride, or silicon oxynitride.

In some embodiments, the aluminum oxide layer may be formed by an atomic layer deposition (ALD) process. It should be noted that the aluminum oxide layers on the first surface 101 and the second surface 102 may be formed simultaneously.

In some embodiments, the anti-reflection layer may be formed by a plasma-enhanced chemical vapor deposition (PECVD) process. It should be noted that the anti-reflection layers on the first surface 101 and the second surface 102 may be formed simultaneously.

In some embodiments, the operations of forming the first electrode 109 may include: printing a metal paste onto partial surfaces of the first passivation layer 108 away from the first surface 101 using a screen printing process; and performing a sintering process on the metal paste. In some embodiments, the metal paste may contain highly corrosive components such as glass. During sintering, the corrosive components at least etch the first passivation layer 108, allowing the metal paste to penetrate through the first passivation layer 108 onto the first doped semiconductor layer 105, thereby forming the first electrode 109. It should be noted that the operations of forming the second electrode 119 are similar to the operations of forming the first electrode 109, and can be referred to the description provided above about the operations of forming the first electrode 109.

In some embodiments, the metal paste may include at least one of silver, copper, tin, gold, lead, or nickel.

In summary, by sequentially performing etching on the initial first region 141 using a first etching solution containing a first additive and a second etching solution containing a second additive, the surface of the finally formed first pyramid 113 has a plurality of protruding blocks 143, such that a surface roughness of the first pyramid 113 is greatly increased, thereby enhancing a light-trapping effect of the first pyramid 113 on incident light. Consequently, a reflectivity of the first textured surface 103 including rough-surfaced first pyramids 113 is further reduced, allowing a second region 121 to absorb more light and generate more charge carriers. This effectively increases the short-circuit current and improves the photovoltaic conversion efficiency of the solar cell.

Some embodiments of the present disclosure provide a photovoltaic module, which is configured to convert received light energy into electrical energy. The photovoltaic module according to some embodiments of the present disclosure will be further described in detail below in conjunction with the accompanying drawings. It should be noted that description identical or corresponding to the previous embodiments are not repeated in detail herein.

Referring to FIGS. 1-10, and FIGS. 16 and 17, the photovoltaic module includes: at least one cell string formed by connecting a plurality of the solar cells 40 according to any of the foregoing embodiments, or by connecting a plurality of solar cells 40 manufactured using the manufacturing method according to any of the foregoing embodiments; at least one encapsulant film 41 configured to cover a surface of the at least one cell string; and at least one cover plate 42 configured to cover a surface of the at least one encapsulant film 41 away from the at least one cell string. The solar cells 40 are electrically connected as a whole sheet or in a plurality of divided sheets to form a plurality of cell strings, and the plurality of cell strings are electrically connected in series and/or in parallel.

FIG. 16 is a partial perspective view of a photovoltaic module according to some embodiments of the present disclosure, and FIG. 17 is a sectional view of the photovoltaic module in FIG. 16 in a cross-sectional direction MM1.

In some embodiments, the solar cell 40 includes, but is not limited to, a passivated emitter and rear cell (PERC), an interdigitated back contact cell, a tunnel oxide passivated contact (TOPCon) cell, a heterojunction technology (HIT/HJT) cell, a thin-film solar cell, or a tandem cell, or any combination thereof. Specifically, the thin-film solar cell includes, but is not limited to, a perovskite thin-film solar cell, a copper indium selenide thin-film solar cell, a gallium arsenide thin-film solar cell, or a cadmium sulfide thin-film solar cell. The tandem cell includes, but is not limited to, a perovskite cell stacked on a crystalline silicon cell, a perovskite cell stacked on another perovskite cell, or a perovskite cell stacked on a thin-film solar cell.

In some embodiments, the solar cell 40 may be a monocrystalline silicon solar cell, a polycrystalline silicon solar cell, an amorphous silicon solar cell or a multi-compound solar cell, where the multi-compound solar cell may be a cadmium sulfide solar cell, a gallium arsenide solar cell, a copper indium selenide solar cell or a perovskite solar cell. In addition, the solar cell 40 may be either a full-size solar cell or a segmented solar cell, where the segmented solar cell refers to a solar cell formed from a complete full-size cell through a cutting process.

In some embodiments, referring to FIG. 16, the plurality of cell strings may be electrically connected by a conductive ribbon 402. FIG. 16 merely illustrates an example of a positional relationship among solar cells, where arrangement directions of electrodes having the same polarity of the cells are the same, that is, the electrodes having a positive polarity of each cell are arranged toward the same side, such that the conductive ribbons respectively connect different sides of two adjacent cells. In some embodiments, the cells may also be arranged in a way that the electrodes having different polarities face the same side, that is, the electrodes of adjacent cells are sequentially arranged in the order of a first polarity, a second polarity, and a first polarity, respectively, in which case, the conductive ribbons connect two adjacent cells located on the same side.

In some embodiments, no spacing is provided between the cells, that is, the cells are overlapped with each other.

In some embodiments, the encapsulant film 41 includes a first encapsulation layer and a second encapsulation layer, where the first encapsulation layer covers one of a front surface or a back surface of the solar cell 40, and the second encapsulation layer covers the other of the front surface or the back surface of the solar cell 40. Specifically, at least one of the first encapsulation layer or the second encapsulation layer can be an organic encapsulant film, such as a polyvinyl butyral (PVB) film, an ethylene-vinyl acetate (EVA) film, a polyolefin elastomer (POE) film, or a polyethylene terephthalate (PET) film. Alternatively, at least one of the first encapsulation layer or the second encapsulation layer can be an EP film, an EPE film, or a PVP film. The EP film refers to a co-extruded film formed by laminating an EVA film and a POE film. The EPE film refers to a co-extruded film formed by sequentially laminating an EVA film, a POE film, and an EVA film. The PVP film refers to a co-extruded film formed by laminating a POE film, an EVA film, and a POE film. The co-extruded film can be prepared by sequentially extruding one or more raw materials onto another pre-formed film during the film processing, or by adhering different pre-formed films together.

In some embodiments, the first encapsulation layer and the second encapsulation layer may have a boundary line prior to lamination. After the lamination process, when forming the photovoltaic module, the distinction between the first encapsulation layer and the second encapsulation layer is no longer present, that is, the first encapsulation layer and the second encapsulation layer together form an integrated encapsulant film 41.

In some embodiments, the cover plate 42 may be a glass cover plate, a plastic cover plate, or other light-transmitting cover plate. Specifically, a surface of the cover plate 42 facing the encapsulant film 41 may be a textured surface or a velvet-like surface having a plurality of raised structures, thereby increasing the utilization of incident light. The cover plate 42 includes a first cover plate and a second cover plate, where the first cover plate is opposite the first encapsulation layer, and the second cover plate is opposite the second encapsulation layer.

In some embodiments, the solar cell 40 may be a busbar cell or a busbar-free cell.

It may be understood by those skilled in the art that the above embodiments are particular embodiments to implement the present disclosure, and in a practical application, various changes can be made to the form and details without departing from the spirit and scope of the embodiments of the present disclosure. Those skilled in the art may make variations or modifications without departing from the scope of the embodiments of the present disclosure, therefore, the scope of protection of the embodiments of the present disclosure shall be subject to the scope of protection as defined by the claims.

## Claims

1. A solar cell, comprising:
a substrate (100) including a first surface (101) and an opposing second surface (102), wherein the first surface (101) has a first region (111) and a second region (121) alternately formed along a first direction (X), and the first region (111) has a first textured surface (103) including a plurality of first pyramids (113);
wherein a respective first pyramid of at least some of the plurality of first pyramids (113) includes a main body portion (123) and enclosing portions (133) formed on a lateral surface (123a) of the main body portion (123) and stacked in a direction perpendicular to the lateral surface (123a);
wherein the main body portion (123) is a pyramid-like structure having a plurality of lateral edges (123b), and a lateral surface (123a) is between two adjacent lateral edges (123b); and
wherein the main body portion (123) further includes a bottom surface (123c) connecting the plurality of lateral surfaces (123a), a respective enclosing portion of the enclosing portions (133) extends toward the bottom surface (123c) along a second direction (Y), and includes a respective protruding block (143) at an end of the respective enclosing portion (133) away from the bottom surface (123c) and protruding out of an adjacent enclosing portion on a side of the respective enclosing portion (133) away from the main body portion (123).

2. The solar cell according to claim 1, wherein the protruding block (143) includes an extension surface (143a) extending toward the bottom surface (123c) along the second direction (Y) that is parallel to the lateral surface (123a), and a step surface (143b) connecting the main body portion (123) and the extension surface (143a), or connecting adjacent extension surfaces (143a); and
wherein an angle between the step surface (143b) and the second direction (Y) is less than or equal to 90°.

3. The solar cell according to claim 2, wherein the step surface (143b) is a substantially flat surface or a curved surface.

4. The solar cell according to any one of claims 1 to 3, wherein a portion of the main body portion (123) includes a pit (153) away from the bottom surface (123c).

5. The solar cell according to any one of claims 1 to 4, wherein at least some of the enclosing portions (133) surround the plurality of lateral surfaces (123a) of the main body portion (123), and/or a number of enclosing portions (133) formed on different lateral surfaces (123a) is the same or different.

6. The solar cell according to any one of claims 1 to 5, wherein the respective enclosing portion of the enclosing portions (133) has an end face (133c) at the bottom surface (123c) of the main body portion (123), and the bottom surface (123c) and end faces (133c) of the enclosing portions (133) form a base of the respective first pyramid (113).

7. The solar cell according to any one of claims 1 to 6, further including:
a first doped semiconductor layer (105) doped with a first dopant formed on the second region (121), and portions of the substrate (100) in the first region (111) are recessed toward the second surface (102);
a tunneling layer (106) formed on the second surface (102);
a second doped semiconductor layer (107) doped with a second dopant and formed on a side of the tunneling layer (106) away from the second surface (102), wherein the first dopant and the second dopant have different conductivity types;
a first passivation layer (108) formed on a side of the first doped semiconductor layer (105) away from the substrate (100) and on the first region (111);
a second passivation layer (118) formed on a side of the second doped semiconductor layer (107) away from the tunneling layer (106);
a first electrode (109) embedded in the first passivation layer (108) and in ohmic contact with the first doped semiconductor layer (105); and
a second electrode (119) embedded in the second passivation layer (118) and in ohmic contact with the second doped semiconductor layer (107).

8. The solar cell according to any one of claims 1 to 7, wherein the second region (121) has a polished flat surface or a second textured surface (104), and the second textured surface (104) includes a plurality of second pyramids (114);
wherein an included angle between two opposite lateral edges (123b) of the main body portion (123) is less than an included angle between two opposite lateral edges (123b) of a respective second pyramid of the plurality of second pyramids (114); and/or
wherein in a same disposition area, a number of disposed second pyramids (114) is less than a number of disposed first pyramids (113); and/or a height of the respective second pyramid is greater than a height of the respective first pyramid (113).

9. A method for manufacturing a solar cell, comprising:
providing an initial substrate (110), wherein the initial substrate (110) includes an initial first surface (131) and an opposing initial second surface (112), and the initial first surface (131) includes an initial first region (141) and an initial second region (151) alternately arranged along a first direction (X);
performing a first texturing treatment on the initial first region (141) using a first etching solution containing a first additive to form a plurality of initial first pyramids (173), wherein the first additive is used to slow down an etching rate of the initial substrate (110) during the first texturing treatment; and
performing a second texturing treatment on the initial first region (141) using a second etching solution containing a second additive;
wherein during the second texturing treatment, the second additive is adsorbed on at least portions of surfaces of the plurality of initial first pyramids (173), and the portions of surfaces of the plurality of initial first pyramids (173) with the second additive function as a protected region, and the second additive is used to slow down an etching rate of the protected region during the second texturing treatment, to convert the initial first region (141) into a first region (111) having a first textured surface (103) including a plurality of first pyramids (113), a remaining portion of the initial substrate (110) serves as the substrate (100), and the initial second region (151) functions as a second region (121) of the substrate (100);
wherein a respective first pyramid of at least some of the plurality of first pyramids (113) includes a main body portion (123) and enclosing portions (133) formed on a lateral surface (123a) of the main body portion (123) and stacked in a direction perpendicular to the lateral surface (123a);
wherein the main body portion (123) is a pyramid-like structure having a plurality of lateral edges (123b), and a lateral surface (123a) is between two adjacent lateral edges (123b); and
wherein the main body portion (123) further includes a bottom surface (123c) connecting the plurality of lateral surfaces (123a), a respective enclosing portion of the enclosing portions (133) extends toward the bottom surface (123c) along a second direction (Y), and includes a respective protruding block (143) at an end of the respective enclosing portion (133) away from the bottom surface (123c) and protruding out of an adjacent enclosing portion on a side of the respective enclosing portion (133) away from the main body portion (123).

10. The method according to claim 9, wherein a material of the first additive includes a cellulose active agent containing carboxyl and aldehyde groups, and a material of the second additive includes a surface ionic active agent.

11. The method according to claim 9 or claim 10, wherein the initial first surface (131) has a second textured surface (104) including a plurality of second pyramids (114), and after providing the initial substrate (110) and before performing the first texturing treatment, the method further includes:
forming a first doped semiconductor film doped with a first dopant on the initial first surface (131); and
performing a laser processing on a portion of the first doped semiconductor film and a portion of the initial substrate (110) in the initial first region (141) to remove the portion of the first doped semiconductor film in the initial first region (141), and to remove the second pyramids (114) in the initial first region (141), such that the portion of the initial substrate (110) in the initial first region (141) is recessed toward the initial second surface (112), and a remaining portion of the first doped semiconductor film in the initial second region (151) serves as a first doped semiconductor layer (105).

12. The method according to claim 11, further including:
forming a tunneling layer (106) on the second surface (102);
forming a second doped semiconductor layer (107) doped with a second dopant on a side of the tunneling layer (106) away from the second surface (102), wherein the first dopant and the second dopant have different conductivity types;
forming a first passivation layer (108) on a side of the first doped semiconductor layer (105) away from the substrate (100) and on the first region (111);
forming a second passivation layer (118) on a side of the second doped semiconductor layer (107) away from the tunneling layer (106);
forming a first electrode (109), wherein the first electrode (109) is embedded in the first passivation layer (108) and in ohmic contact with the first doped semiconductor layer (105); and
forming a second electrode (119), wherein the second electrode (119) is embedded in the second passivation layer (118) and in ohmic contact with the second doped semiconductor layer (107).

13. The method according to claim 12, wherein the first passivation layer (108) and the second passivation layer (118) are formed using a plasma-enhanced chemical vapor deposition (PECVD) process;
wherein a structure on the substrate (100) where the first doped semiconductor layer (105), the tunneling layer (106), and the second doped semiconductor layer (107) are formed is taken as a target structure, and during the PECVD process, the target structure is placed in a graphite boat, and a number of contact locking points between the graphite boat and the target structure are greater than or equal to five.

14. The method according to claim 13, wherein the target structure has four sides, each of two opposing sides of the four sides has at least two respective contact locking points that are spaced from each other and configured to lock with the graphite boat, and one of the other two sides of the four sides has at least one contact locking point configured to lock with the graphite boat.

15. A photovoltaic module, comprising:
at least one cell string formed by connecting a plurality of solar cells (40), wherein each solar cell of the plurality of solar cells (40) is the solar cell according to any one of claims 1 to 8, or a solar cell manufactured using the method according to any one of claims 9 to 14;
at least one encapsulant film (41) configured to cover a surface of the at least one cell string; and
at least one cover plate (42) configured to cover a surface of the at least one encapsulant film (41) away from the at least one cell string.
